# EUROPÄISCHE PATENTSCHRIFT

(11) **EP 1 116 274 B1**
(45) Veröffentlichungstag und Bekanntmachung des Hinweises auf die Patenterteilung: **17.11.2004**
(21) Anmeldenummer: 99955704.4
(22) Anmeldetag: 14.09.1999
(51) Int. Cl.: H01L 27/085

(54) **ELEKTRONISCHE SCHALTEINRICHTUNG MIT MINDESTENS ZWEI HALBLEITERBAUELEMENTEN**
ELECTRONIC SWITCHING DEVICE WITH AT LEAST TWO SEMICONDUCTOR COMPONENTS
DISPOSITIF DE COMMUTATION ELECTRONIQUE COMPRENANT AU MOINS DEUX ELEMENTS SEMI-CONDUCTEURS

(30) Priorität: 25.09.1998 DE 19844130
(43) Veröffentlichungstag der Anmeldung: 18.07.2001
(73) Patentinhaber: SIEMENS AKTIENGESELLSCHAFT, 80333 München (DE)
(72) Erfinder: DOHNKE, Karl-Otto, D-96117 Memmelsdorf (DE); STEPHANI, Dietrich, D-91088 Bubenreuth (DE); WEIS, Benno, D-91334 Hemhofen (DE); MITLEHNER, Heinz, D-91080 Uttenreuth (DE)
(86) Internationale Anmeldenummer: PCT/DE1999/002924
(87) Internationale Veröffentlichungsnummer: WO 2000/019536

(56) Entgegenhaltungen:
- EP-A- 0 822 600
- WO-A-97/34322
- US-A- 4 394 590
- US-A- 4 523 111
- US-A- 4 945 266
- US-A- 5 406 096
- PATENT ABSTRACTS OF JAPAN vol. 012, no. 111 (E-598), 8. April 1988 (1988-04-08) -& JP 62 239719 A (ANRITSU CORP), 20. Oktober 1987 (1987-10-20) in der Anmeldung erwähnt

## Beschreibung

Die Erfindung betrifft eine elektronische Schalteinrichtung, die zumindest ein erstes Halbleiterbauelement mit einem ersten Kathodenanschluß, einem ersten Anodenanschluß und einem ersten Gitteranschluß und ein zweites Halbleiterbauelement mit einem zweiten Kathodenanschluß, einem zweiten Anodenanschluß und einem zweiten Gitteranschluß umfaßt, wobei der erste Anodenanschluß und der zweite Kathodenanschluß elektrisch kurzgeschlossen sind, und eine am ersten Gitteranschluß anlegbare Steuerspannung teilweise auch am zweiten Gitteranschluß ansteht. Eine derartige elektronische Schalteinrichtung ist aus der DE 34 07 975 C2 bekannt.

Auch in der WO 97/34322 A1 und in der US 5,396,085 wird jeweils eine elektronische Schalteinrichtung beschrieben, die bis auf das Merkmal der teilweise auch am zweiten Gitteranschluß anstehenden Steuerspannung alle anderen der vorstehend genannten Merkmale aufweist. Die in diesen beiden Dokumenten jeweils offenbarte elektronische Schalteinrichtung umfaßt außerdem eine elektrisch leitende Verbindung zwischen dem ersten Kathodenanschluß und dem zweiten Gitteranschluß. Diese Zusammenschaltung zweier Halbleiterbauelemente wird auch als Kaskode-Schaltung bezeichnet. Die elektronische Schalteinrichtung dient zum Schalten eines hohen elektrischen Stroms und ist auch für eine hohe Sperrspannung ausgelegt. Das erste Halbleiterbauelement besteht aus Silicium (Si) und sorgt aufgrund der hohen Ladungsträgerbeweglichkeit im Silicium für eine hohe Schaltgeschwindigkeit. Das zweite Halbleiterbauelement besteht aus einem Halbleitermaterial mit einer Durchbruchfeldstärke von mehr als 10⁶ V/cm, insbesondere aus Siliciumcarbid (SiC), und sorgt für die hohe Sperrspannung.

Demgegenüber weist eine nur in Silicium realisierte elektronische Schalteinrichtung, beispielsweise ein spannungsgesteuerter Si-MOSFET (Metal Oxide Semiconductor Field Effect Transistor), im Durchlaßzustand statische Verluste auf, die mit der vom Si-MOSFET zu bewältigenden Sperrspannung im Sperrzustand steigen. In Silicium wird die statische Verlustleistung eines für eine Sperrspannung von über 600 V ausgelegten Leistungs-MOSFETs bei einem Durchlaßstrom von mehr als 5 A zu groß. Deshalb verwendet man bei Anwendungen mit einer Sperrspannung und einem Durchlaßstrom in der genannten Größenordnung trotz der hohen Schaltgeschwindigkeit keinen Si-MOSFET mehr.

Aus der WO 97/34322 A1 geht hervor, daß das erste Halbleiterbauelement aus Si und auch die elektronische Schalteinrichtung insgesamt bei einer vorgegebenen Polarität der Betriebsspannung über eine an dem ersten Gitteranschluß anstehende Steuerspannung zwischen einem Durchlaß- und einem Sperrzustand umgeschaltet werden kann. Wenn sich die elektronische Schalteinrichtung in ihrem Sperrzustand befindet, schnürt eine Verarmungszone (Zone mit Verarmung an Ladungsträgern und damit hohem elektrischen Widerstand; Raumladungszone) wenigstens eines p-n-Übergangs mindestens ein Kanalgebiet des zweiten Halbleiterbauelements aus SiC ab. Der größte Teil der zwischen dem ersten Kathodenanschluß und dem zweiten Anodenanschluß anliegenden zu sperrenden Betriebsspannung fällt über dieser Verarmungszone ab. Aufgrund der hohen Durchbruchfeldstärke des verwendeten Siliciumcarbids kann der p-n-Übergang, insbesondere seine Verarmungszone, eine deutlich höhere Sperrspannung tragen als ein in Silicium gebildeter p-n-Übergang mit gleichen Ladungsträgerkonzentrationen und Abmessungen. Da der größte Teil der Sperrspannung innerhalb des zweiten Halbleiterbauelements abfällt, muß das erste Halbleiterbauelement somit nur für den verbleibenden Teil der Sperrspannung ausgelegt werden. Dies hat eine deutlich reduzierte Verlustleistung des ersten Halbleiterbauelements aus Silicium im Durchlaßbetrieb zur Folge.

Im Durchlaßzustand wird die Verarmungszone des p-n-Übergangs im zweiten Halbleiterbauelement mit Ladungsträgern überschwemmt und das Kanalgebiet geöffnet. Durch das Kanalgebiet kann nun ein elektrischer Strom fließen. Die gesamte Verlustleistung der elektronischen Schalteinrichtung umfaßt dann die Verluste im ersten und zweiten Halbleiterbauelement. Diese Gesamtverluste sind nun deutlich kleiner als bei einem für die gleiche Sperrspannung ausgelegten reinen Silicium-Halbleiterbauelement.

Aus der WO 97/34322 A1 ist außerdem eine Integration der beiden Halbleiterbauelemente zu einer hybriden Halbleiterstruktur bekannt. Die ganzflächig auf der Oberfläche des zweiten Halbleiterbauelements aus SiC aufgebrachte Metallisierung für den zweiten Kathodenanschluß dient dabei gleichzeitig als Metallisierung für den ersten Anodenanschluß des ersten Halbleiterbauelements aus Si.

Aus der US 5,396,085 ist eine ähnliche elektronische Schalteinrichtung mit einer Kaskode-Schaltung eines ersten Halbleiterbauelements aus Si und eines zweiten Halbleiterbauelements aus SiC bekannt. Ein Unterschied besteht jedoch in der Verwendung eines Composite-Substrats, das sowohl einen Bereich aus Silicium als auch einen Bereich aus Siliciumcarbid enthält. Die beiden Halbleiterbauelemente sind in jeweils einem dieser Bereiche des Composite-Substrats realisiert.

Aus der JP 61-161015 A1 ist außerdem eine Kaskode-Schaltung eines selbstsperrenden MOSFETs aus Silicium und eines SITs (Stated Induction Transistor) aus einem Verbundhalbleiter, beispielsweise aus Galliumarsenid (GaAs) oder Indiumphosphid (InP), bekannt. Diese elektronische Einrichtung dient dabei in erster Linie zum extrem schnellen Schalten bei einer Hochfrequenz-Anwendung.

Allgemein wirkt bei der beschriebenen Kaskode-Schaltung der Durchlaßwiderstand des ersten Halbleiterbauelements gegenkoppelnd am zweiten Gitteranschluß des zweiten Halbleiterbauelements. Mit Erhöhung des Stroms durch die elektronische Schalteinrichtung steigt auch die negative Vorspannung des zweiten Gitteranschlusses gegenüber dem zweiten Kathodenanschluß. Die Verarmungszone des p-n-Übergangs, der sich zwischen den beiden Anschlüssen befindet, dehnt sich damit weiter in das für den Stromfluß vorgesehene Kanalgebiet aus. Damit erhöht sich mit wachsendem Strom durch die elektronische Schalteinrichtung aber der Durchlaßwiderstand des zweiten Halbleiterbauelements.

Um diesen Effekt zumindest teilweise zu beheben, ist es bei der mit der DE 34 07 975 C2 offenbarten elektrischen Schalteinrichtung vorgesehen, einen p-n-Übergang des zweiten Halbleiterbauelements entsprechend vorzuspannen. Dieser p-n-Übergang befindet sich innerhalb des als Sperrschicht-Feldeffekttransistor (JFET) ausgebildeten zweiten Halbleiterbauelements zwischen dem zweiten Gitteranschluß und dem zweiten Kathodenanschluß. Die Vorspannung wird dabei so dimensioniert, daß sich der p-n-Übergang und damit auch der JFET insgesamt in einem bipolaren Leitungszustand befindet. Die Vorspannung ist also größer als die Diffusionsspannung dieses p-n-Übergangs. Für Silicium liegt die Diffusionsspannung in der Größenordnung von 0,6 bis 0,7 V. Durch den bipolaren Betrieb des p-n-Übergangs erfolgt die Ansteuerung des zweiten Halbleiterbauelements nun nicht mehr leistungslos. Es fließt ein Strom über den p-n-Übergang. Aufgrund dieses Stromflusses muß der zweite Gitteranschluß stabiler und insbesondere auch größer ausgelegt werden, wodurch Platz für den eigentlichen aktiven Bereich des zweiten Halbleiterbauelements verloren geht. Dadurch sinkt das Stromschaltvermögen der elektrischen Schalteinrichtung. Der Stromfluß an dem zweiten Gitteranschluß führt außerdem dazu, daß eine Kapazität des p-n-Übergangs zunächst auf- bzw. umgeladen werden muß, wenn ein Schaltvorgang eingeleitet wird. Damit sinkt auch die erzielbare Schaltgeschwindigkeit.

Es ist nun Aufgabe der Erfindung, eine elektronische Schalteinrichtung der eingangs bezeichneten Art anzugeben, die einen niedrigen Durchlaßwiderstand und gleichzeitig ein gutes Stromschaltvermögen sowie eine hohe Schaltgeschwindigkeit aufweist.

Diese Aufgabe wird erfindungsgemäß gelöst mit den kennzeichnenden Merkmalen des Anspruchs 1. Bei der elektronischen Schalteinrichtung sind vorgesehen Einstellungsmittel zum Einstellen einer Gitter-Kathoden-Spannung des zweiten Halbleiterbauelements, die kleiner ist als eine Diffusionsspannung eines p-n-Übergangs, der sich innerhalb des zweiten Halbleiterbauelements zwischen dem zweiten Gitteranschluß und dem zweiten Kathodenanschluß befindet.

Die Erfindung beruht dabei auf der Erkenntnis, daß sich die vorteilhafte Wirkung des ersten und zweiten Halbleiterbauelements mit ihren jeweiligen spezifischen Vorteilen auch dann erzielen läßt, wenn der zweite Gitteranschluß nicht mit dem ersten Kathodenanschluß kurzgeschlossen ist. Ein Auftrennen dieser beim Stand der Technik vorgesehenen elektrischen Verbindung bietet außerdem den Vorteil, die gegenkoppelnde Wirkung des Durchlaßwiderstands des ersten Halbleiterbauelements auf das zweite Halbleiterbauelement mit der Folge einer Erhöhung des Durchlaßwiderstands des zweiten Halbleiterbauelements zu vermeiden. Durch diese Entkopplung ist der Durchlaßwiderstand des zweiten Halbleiterbauelements im Nennstrombereich im wesentlichen unabhängig von einem über die elektronische Schalteinrichtung fließenden elektrischen Strom. Die Teilkopplung der am ersten Gitteranschluß anstehenden Steuerspannung auf den zweiten Gitteranschluß bewirkt nämlich, daß eine durch eine Diffusionsspannung bewirkte Verarmungszone in einem Kanalgebiet des zweiten Halbleiterbauelements deutlich reduziert wird, wodurch sich dann der reduzierte Durchlaßwiderstand ergibt. Mit dem Durchlaßwiderstand des zweiten Halbleiterbauelements reduziert sich auch der gesamte Durchlaßwiderstand der elektronischen Schalteinrichtung.

Dadurch, daß der am Gitteranschluß anliegende Teil der Steuerspannung eine Gitter-Kathoden-Spannung im zweiten Halbleiterbauelement bewirkt, die stets kleiner ist als die Diffusionsspannung, wird auch der p-n-Übergang nicht in den bipolaren, d.h. nicht in den leitenden Zustand geschaltet. Es kommt zu keinem nennenswerten Stromfluß am zweiten Gitteranschluß. Damit ergibt sich ein sehr niedriger Durchlaßwiderstand bei gleichbleibend gutem Stromschaltvermögen und ebenfalls gleichbleibend hoher Schaltgeschwindigkeit. Die Ansteuerung erfolgt vorteilhafterweise nach wie vor leistungslos, so daß die Dimensionierung des zweiten Gitteranschlusses unverändert klein bleiben kann. Außerdem erfolgt auch keine nennenswerte bipolare Injektion in den p-n-Übergang.

Durch die Maßnahme, einen Teil der am ersten Gitteranschluß anstehenden Steuerspannung auch an den zweiten Gitteranschluß anzulegen, wird das Sperrvermögen der elektronischen Schalteinrichtung in keiner Weise beeinträchtigt. Da für die Umschaltung in den Sperrzustand insbesondere eine Steuerspannung von 0 V am ersten Gitteranschluß notwendig ist, befindet sich somit auch der zweite Gitteranschluß praktisch auf dem gleichen Potential wie der erste Kathodenanschluß. Damit liegen im Sperrzustand jedoch Verhältnisse vor, die denen vom Stand der Technik vergleichbar sind. Die für die Umschaltung in den Durchlaßzustand erforderliche positive Steuerspannung bewirkt gleichzeitig aufgrund der Teilkopplung zum zweiten Gitteranschluß jedoch auch eine verbesserte Stromtragfähigkeit des Kanalgebiets für den Stromfluß im zweiten Halbleiterbauelement. Im Sperrzustand wird dieses Kanalgebiet wie beim Stand der Technik durch eine Verarmungszone abgeschnürt, wobei die gesamte Verarmungszone einen großen Teil der an der elektronischen Schalteinrichtung anstehenden Sperrspannung trägt.

Besondere Ausgestaltungen der elektronischen Schalteinrichtung nach der Erfindung ergeben sich aus den abhängigen Unteransprüchen.

Besonders günstig ist eine Ausführungsform, bei der der am Gitteranschluß anliegende Teil der Steuerspannung zu einer Gitter-Kathoden-Spannung mit einem Wert von höchstens zwei Dritteln der Diffusionsspannung des p-n-Übergangs, der sich im zweiten Halbleiterbauelement zwischen dem zweiten Gitteranschluß und dem zweiten Kathodenanschluß befindet, führt. Dieser zusätzliche Sicherheitsabstand zur Diffusionsspannung reduziert den ohnehin schon niedrigen Stromfluß über den p-n-Übergang weiter.

Vorteilhaft läßt sich die elektrische Teilkopplung der Potentiale an den beiden Gitteranschlüsse über einen zwischen die beiden Gitteranschlüsse geschalteten, ersten elektrischen Kopplungswiderstand realisieren. Über die Dimensionierung dieses ersten Kopplungswiderstands kann der Anteil der am ersten Gitteranschluß anstehenden Steuerspannung, der am zweiten Gitteranschluß abfallen soll, gut eingestellt werden. Noch exakter kann diese Einstellung erfolgen, wenn wie in einer weiteren vorteilhaften Ausführungsform der an dem zweiten Gitteranschluß abfallende Anteil der Steuerspannung über einen Spannungsteiler, der zwischen den ersten Gitteranschluß und den ersten Kathodenanschluß geschaltet ist, abgegriffen wird. Dieser Spannungsteiler umfaßt ein en ersten und einen zweiten Kopplungswiderstand.

Zur Verbesserung des dynamischen Verhaltens ist in einer vorteilhaften Ausgestaltung vorgesehen, eine erste Diode parallel zu dem ersten Kopplungswiderstand und eine zweite Diode parallel zu dem zweiten Kopplungswiderstand zu schalten. Dadurch wird beim Umschalten zwischen dem Sperr- und dem Durchlaßzustand der Auf- oder Entladevorgang einer Kapazität zwischen dem zweiten Gitteranschluß und dem zweiten Kathodenanschluß beschleunigt.

In einer bevorzugten Ausführungsform ist der erste Kopplungswiderstand oder der Spannungsteiler rein ohmsch ausgebildet.

Es ist jedoch auch eine andere Widerstandsart, beispielsweise eine kapazitive oder eine beliebig komplexe, möglich.

Vorteilhaft ist in einer Ausführungsform das erste Halbleiterbauelement mit dem Halbleitermaterial Silicium realisiert. Silicium ermöglicht aufgrund seiner hohen Ladungsträgerbeweglichkeit eine sehr hohe Schaltgeschwindigkeit.

Eine weitere vorteilhafte Ausgestaltung sieht vor, das erste Halbleiterbauelement als selbstsperrenden MOSFET auszubilden. In diesem Fall läßt sich das erste Halbleiterbauelement über eine an den ersten Gitteranschluß anstehende Spannung in den Durchlaßzustand schalten. Der erste Gitteranschluß entspricht in dieser Ausführungsform der Gate-Elektrode des MOSFETs. Bevorzugt ist ein selbstsperrender MOSFET mit einem n-leitenden Kanal. Damit läßt sich der MOSFET über eine positive Steuerspannung von dem Sperr- in den Durchlaßzustand schalten.

Vorteilhaft ist in einer anderen Ausführungsform das zweite Halbleiterbauelement mit einem Halbleitermaterial mit einer Durchbruchfeldstärke von wengistens 10⁶ V/cm realisiert. Dadurch resultiert das von dem zweiten Halbleiterbauelement im Sperrzustand geforderte hohe Sperrvermögen. Geeignete Halbleitermaterialien sind Diamant, Aluminiumnitrid (A1N), Galliumnitrid (GaN), Indiumnitrid (InN) und insbesondere Siliciumcarbid (SiC). Bei letzterem sind insbesondere die Polytypen 3C-, 4H-, 6H- und 15R-SiC geeignet.

Eine weitere vorteilhafte Ausgestaltungsform beinhaltet ein zweites Halbleiterbauelement, das als selbstleitender Feldeffekttransistor ausgebildet ist. Dadurch läßt sich der über die elektronische Schalteinrichtung fließende Strom sehr einfach und schnell nur durch eine Schalthandlung am ersten Halbleiterbauelement steuern.

Der selbstleitende Feldeffekttransistor ist vorzugsweise als Sperrschicht-Feldeffekttransistor (Junction Field Effect Transistor = JFET) ausgebildet. Bei dieser Transistorart wird der Stromfluß durch eine von außen beeinflußbare Sperrschicht, insbesondere eine Verarmungszone beispielsweise eines p-n-Übergangs, gesteuert. Die räumliche Ausdehnung dieser Verarmungszone ist dann für die Größe des fließenden Stromes maßgeblich. Abhängig von der an dem zweiten Gitteranschluß anstehenden Spannung gibt die Verarmungszone dann ein mehr oder weniger breites Kanalgebiet für den Stromfluß frei oder sie schnürt dieses ab.

Die folgenden Ausgestaltungen sind bevorzugte Ausführungsformen des Sperrschicht-Feldeffekttransistors (JFET).

In einer ersten Ausgestaltung besteht der JFET aus einem n-leitenden ersten Halbleitergebiet. An einer Oberfläche dieses ersten Halbleitergebiets befindet sich innerhalb des ersten Halbleitergebiets ein ebenfalls n-leitendes Kontaktgebiet. Dieses Kontaktgebiet kann gleich wie oder auch höher als das übrige erste Halbleitergebiet dotiert sein. Es ist über den zweiten Kathodenanschluß elektrisch, insbesondere ohmsch, kontaktiert. Ein außerhalb des Kontaktgebiets liegender Bereich der Oberfläche des ersten Halbleitergebiets ist über den zweiten Gitteranschluß elektrisch kontaktiert. Dieser Kontakt kann sowohl ohmsch als auch als Schottky-Kontakt ausgebildet sein. Es ist möglich, daß mehrere Kontaktgebiete und auch mehrere außerhalb dieser Kontaktgebiete liegende Bereiche vorgesehen sind, die dann jeweils durch den zweiten Kathodenanschluß bzw. den zweiten Gitteranschluß kontaktiert sind. An einer der Oberfläche abgewandten Seite ist das erste Halbleitergebiet über den zweiten Anodenanschluß elektrisch, insbesondere ohmsch, kontaktiert. Da der Strom zwischen dem zweiten Kathodenanschluß und dem zweiten Anodenanschluß vertikal, d.h. senkrecht zur Oberfläche, durch das zweite Halbleiterbauelement fließt, wird es auch als vertikaler JFET bezeichnet.

In einer zweiten Ausgestaltung befindet sich innerhalb des ersten Halbleitergebiets an der Oberfläche ein p-leitendes zweites Halbleitergebiet. Dieses ist so hoch dotiert, daß der zweite Gitteranschluß einen ohmschen Kontakt bildet. Es ist auch möglich, daß mehrere zweite Halbleitergebiete in dem JFET enthalten sind. Zwischen dem n-leitenden ersten Halbleitergebiet und gegebenenfalls auch dem ebenfalls n-leitenden Kontaktgebiet einerseits und dem p-leitenden zweiten Halbleitergebiet andererseits wird ein p-n-Übergang mit einer Verarmungszone gebildet. Diese Verarmungszone bildet die über den zweiten Gitteranschluß steuerbare Sperrschicht des JFETs. Durch Anlegen einer entsprechenden Spannung an dem zweiten Gitteranschluß wird ein innerhalb des ersten Kanalgebiets verlaufender Kanal durch diese Verarmungszone abgeschnürt oder sogar komplett überdeckt.

Vorteilhaft ist insbesondere auch eine dritte Ausgestaltung, die ein p-leitendes, innerhalb des ersten Halbleitergebiets vergrabenes Inselgebiet umfaßt. Wahlweise können auch mehrere dieser vergrabenen Inselgebiete vorgesehen sein. Das vergrabene p-leitende Inselgebiet ist dabei insbesondere so angeordnet, daß in einer Projektion senkrecht zur Oberfläche die Projektion des Kontaktgebiets vollständig innerhalb der Projektion des vergrabenen Inselgebiets liegt. Dadurch ergibt sich innerhalb des ersten Halbleitergebiets ein laterales, d.h. parallel zur Oberfläche verlaufendes, n-leitendes Kanalgebiet. Es wird durch die Verarmungszonen des p-n-Übergangs zwischen dem ersten und zweiten Halbleitergebiet einerseits und einem weiteren p-n-Übergang zwischen dem ersten Halbleitergebiet und dem vergrabenen Inselgebiet andererseits begrenzt. Insbesondere im Sperrzustand bietet das vergrabene Inselgebiet Vorteile, da der unterhalb des vergrabenen Inselgebiets gelegene Teil des p-n-Übergangs zu dem ersten Halbleitergebiet einen großen Anteil der Sperrspannung aufnehmen kann.

In einer weiteren Ausgestaltung ist auch das vergrabene Inselgebiet elektrisch leitend mit dem zweiten Gitteranschluß verbunden. Die Verarmungszonen der p-n-Übergänge zwischen den beiden genannten p-leitenden Zonen und dem n-leitenden ersten Halbleitergebiet lassen sich somit über den zweiten Gitteranschluß gemeinsam steuern.

Eine andere vorteilhafte Ausführungsform der elektronischen Schalteinrichtung sieht eine Integration des ersten und zweiten Halbleiterbauelements zu einer hybriden Halbleiterstruktur vor. Als verbindendes Element zwischen den beiden Halbleiterbauelementen dient dabei insbesondere die Elektrodenschicht des ersten Anodenanschlusses und des zweiten Kathodenanschlusses. Da beide Anschlüsse kurzgeschlossen sind, können sie über eine einzige Elektrodenschicht, die sich in der hybriden Halbleiterstruktur zwischen dem ersten und zweiten Halbleiterbauelement über die gesamte Grundfläche der hybriden Halbleiterstruktur erstreckt, realisiert werden. Dadurch können auf einfache Weise mechanische Spannungen an der Schnittstelle zwischen den beiden Halbleiterbauelementen vermieden werden, die insbesondere dann auftreten, wenn beide Halbleiterbauelemente aus unterschiedlichen Halbleitermaterialien bestehen und diese unterschiedlichen Halbleitermaterialien an der Schnittstelle miteinander in Kontakt treten.

Bevorzugte Ausführungsbeispiele werden nunmehr anhand der Zeichnung näher erläutert. Zur Verdeutlichung ist die Zeichnung nicht maßstäblich ausgeführt und gewisse Merkmale sind schematisiert dargestellt. Im einzelnen zeigen
- Figur 1: eine erste elektronische Schalteinrichtung mit erstem und zweitem Halbleiterbauelement,
- Figur 2: eine zweite elektronische Schalteinrichtung mit erstem und zweitem Halbleiterbauelement,
- Figur 3: eine dritte elektronische Schalteinrichtung mit erstem und zweitem Halbleiterbauelement,
- Figur 4: eine hybride Halbleiterstruktur aus erstem und zweitem Halbleiterbauelement,
- Figur 5: ein Ausführungsbeispiel für das zweite Halbleiterbauelement,
- Figur 6: das Ausführungsbeispiel des zweiten Halbleiterbauelements gemäß Figur 5 bei positiver Gitter-Kathoden-Spannung und
- Figur 7: das Ausgangskennlinienfeld des zweiten Halbleiterbauelements gemäß Figur 5.

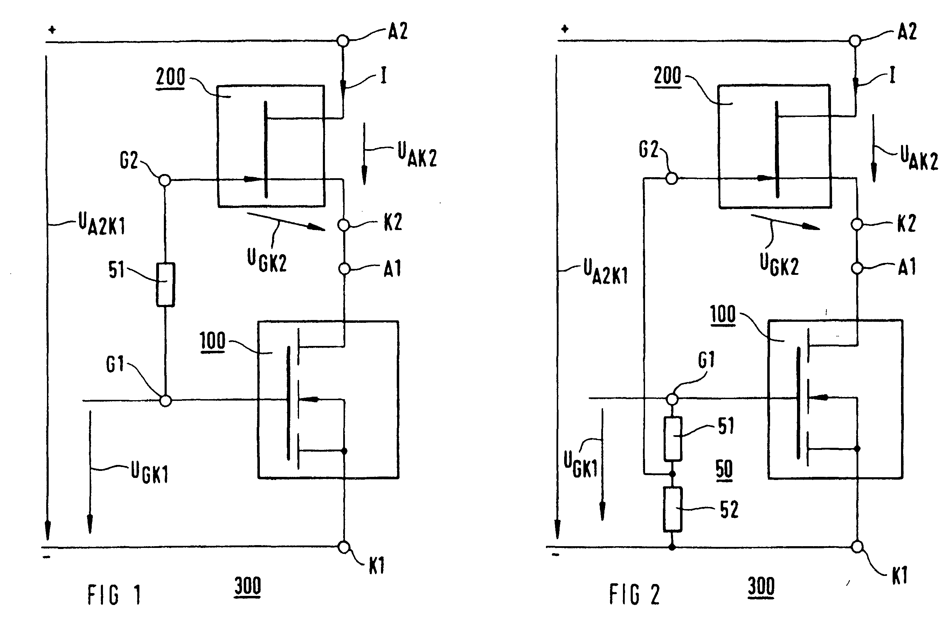

Einander entsprechende Teile sind in den Figuren 1 bis 7 mit denselben Bezugszeichen versehen.

In Figur 1 ist ein erstes Ausführungsbeispiel für eine elektronische Schalteinrichtung 300 dargestellt. Sie besteht aus einem ersten Halbleiterbauelement 100 und einem zweiten Halbleiterbauelement 200. Das erste Halbleiterbauelement 100 ist als selbstsperrender Si-MOSFET und das zweite Halbleiterbauelement 200 als SiC-JFET ausgebildet. Das erste Halbleiterbauelement 100 besitzt einen ersten Anodenanschluß A1, einen ersten Kathodenanschluß K1 und einen ersten Gitteranschluß G1, das zweite Halbleiterbauelement 200 einen zweiten Anodenanschluß A2, einen zweiten Kathodenanschluß K2 und einen zweiten Gitteranschluß G2. Der erste Anodenanschluß A1 und der zweite Kathodenanschluß K2 sind elektrisch kurzgeschlossen.

Die elektronische Schalteinrichtung 300 dient einem verlustarmen und schnellen elektronischen Schalten einer zwischen dem zweiten Anodenanschluß A2 und dem ersten Kathodenanschluß K1 anstehenden elektrischen Betriebsspannung U_{A2K1} oder eines über die elektronische Schalteinrichtung 300 fließenden Stroms I. Liegt, wie in Figur 1 dargestellt, eine positive Betriebsspannung U_{A2K1} an, d.h. der zweite Anodenanschluß A2 hat gegenüber dem ersten Kathodenanschluß positives Potential, so läßt sich die elektronische Schalteinrichtung 300 zwischen einem Sperrzustand und einem Durchlaßzustand umschalten.

Diese Umschaltung erfolgt über eine zwischen dem ersten Gitteranschluß G1 und dem ersten Kathodenanschluß anlegbare Steuerspannung U_{GK1}. Da das erste Halbleiterbauelement 100 ein selbstsperrender Si-MOSFET mit n-leitendem Kanal ist, bewirkt eine positive Steuerspannung U_{GK1} ein Öffnen und eine Steuerspannung U_{GK1} von 0 V ein Schließen des ersten Halbleiterbauelements 100.

Ein Teil der Steuerspannung U_{GK1} wird über einen ersten Kopplungswiderstand 51 an den zweiten Gitteranschluß G2 geführt. Dadurch reduziert sich im Durchlaßzustand der Durchlaßwiderstand des zweiten Halbleiterbauelements 200 und damit auch der der gesamten elektronischen Schalteinrichtung 300. Der erste Kopplungswiderstand 51 ist dabei so zu dimensionieren, daß das Produkt aus einem über den zweiten Gitteranschluß G2 fließenden kapazitiven Ladestrom und dem ersten Kopplungswiderstand 51 stets kleiner gleich als eine sich zwischen dem zweiten Gitteranschluß G2 und dem zweiten Kathodenanschluß K2 im Innern des SiC-JFETs ausbildende Diffusionsspannung ist. Ein SiC-typischer Wert für die Diffusionsspannung ist 3 V.

Im Sperrzustand befindet sich der erste und damit auch der zweite Gitteranschluß G1 bzw. G2 auf dem gleichen Potential wie der erste Kathodenanschluß K1. Die komplette Betriebsspannung U_{A2K1} steht dann u.a. zwischen dem zweiten Anodenanschluß A2 und dem zweiten Gitteranschluß G2 an, wodurch das als SiC-JFET ausgebildete zweite Halbleiterbauelement 200 gesperrt wird und den größten Teil der Betriebsspannung U_{A2K1} aufnimmt.

Das erste Halbleiterbauelement 100 wird dann nur noch für den verbleibenden Teil der Betriebsspannung U_{A2K1} ausgelegt. Im allgemeinen ist hierbei eine Dimensionierung für eine maximale zwischen dem ersten Anodenanschluß A1 und dem ersten Kathodenanschluß K1 anliegende Spannung (Durchbruchspannung, Sperrspannung) von unter 350 V, insbesondere unter 100 V und vorzugsweise unter 50 V, ausreichend. Der Si-MOSFET der Firma Siemens vom Typ BUZ 101 mit einer maximalen (Sperr)Spannung von 50 V, einem Durchlaßwiderstand von 60 mΩ und einer dem geforderten Strom im Durchlaßbetrieb entsprechenden Nennstromtragfähigkeit ist dann beispielsweise eine geeignete Wahl. Ein anderer geeigneter Si-MOSFET ist z.B. ein sogenannter HITFET mit zusätzlich integrierter Schutzfunktion gegen eine Übertemperatur oder eine Überspannung. Ein diesbezüglich geeigneter HITFET ist beispielsweise der ebenfalls von der Firma Siemens beziehbare BTS 149 mit einer maximalen (Sperr)Spannung von 60 V, einem Durchlaßwiderstand von 18 mΩ und einem Nennstrom von 19 A. Allgemein ist bei einer Durchbruchspannung von unter 350 V der Kanalwiderstand des Si-MOSFETs größer als der Driftwiderstand. Dadurch ergibt sich insgesamt ein niedriger Durchlaßverlust.

Die über den ersten Kopplungswiderstand 51 teilweise an den zweiten Gitteranschluß G2 herangeführte Steuerspannung U_{GK1} verhindert im Durchlaßzustand zumindest weitgehend, daß sich mit steigendem Strom I aufgrund der gegenkoppelnden Wirkung des Durchlaßwiderstands des ersten Halbleiterbauelements 100 eine negative Gitter-Kathoden-Spannung U_{GK2} zwischen dem zweiten Gitteranschluß G2 und dem zweiten Kathodenanschluß K2 ausbildet. Eine negative Gitter-Kathoden-Spannung U_{GK2} bewirkt nämlich eine Verengung eines für den Stromfluß vorgesehenen Kanalgebiets und somit eine Erhöhung des Durchlaßwiderstands des zweiten Halbleiterbauelements 200. Durch die über den ersten Kopplungswiderstand 51 auf den zweiten Gitteranschluß G2 teilgekoppelte Steuerspannung U_{GK1} stellt sich zunächst eine positive Gitter-Kathoden-Spannung U_{GK2} am zweiten Halbleiterbauelement 200 ein, wodurch das Kanalgebiet geweitet und der Durchlaßwiderstand somit reduziert wird.

Eine zwischen dem zweiten Anodenanschluß A2 und dem zweiten Kathodenanschluß K2 abfallende Spannung wird mit Anoden-Kathoden-Spannung U_{AK2} des zweiten Halbleiterbauelements 200 bezeichnet.

In Figur 2 ist ein anderes Ausführungsbeispiel für die elektronische Schalteinrichtung 300 dargestellt. Der Unterschied zur elektronischen Schalteinrichtung 300 von Figur 1 besteht in der Kopplung der Steuerspannung U_{GK1} auf den zweiten Gitteranschluß G2. Diese erfolgt im Ausführungsbeispiel von Figur 2 Teil über einen Spannungsteiler 50 zwischen dem ersten Gitteranschluß G1 und dem ersten Kathodenanschluß K1. Der Spannungsteiler 50 beinhaltet neben dem ersten Kopplungswiderstand 51 außerdem einen zweiten Kopplungswiderstand 52. Durch die Wahl eines geeigneten Teilungsverhältnisses für den Spannungsteiler 50 läßt sich der Anteil der Steuerspannung U_{GK1}, der auf den zweiten Gitteranschluß G2 gekoppelt wird, sehr exakt einstellen.

Um die Ansteuerleistung möglichst gering zu halten, ist der Spannungsteiler hochohmig, hier heißt das im kΩ-Bereich, ausgeführt. Ein typischer Wert für den ersten Kopplungswiderstand 51 liegt bei 10 kΩ und für den zweiten Kopplungswiderstand 52 bei 1 kΩ. Damit wird bei einer typischen Steuerspannung U_{GK1} von 15 V ein Anteil von typischerweise 2 V auf den zweiten Gitteranschluß G2 gekoppelt. Allgemein kann die Steuerspannung U_{GK1} Werte zwischen 5 V und 30 V und der auf den zweiten Gitteranschluß G2 gekoppelte Anteil Werte kleiner gleich 3 V annehmen.

Beim Umschalten zwischen Sperr- und Durchlaßzustand wird nun eine Kapazität, die sich,zwischen dem zweiten Gitteranschluß G2 und dem zweiten Kathodenanschluß K2 befindet, über den Spannungsteiler 50 oder zumindest über einen seiner beiden Kopplungswiderstände 51 oder 52 entladen oder aufgeladen. Da die beiden Kopplungswiderstände 51 und 52 des Spannungsteilers 50 aufgrund der erwünschten niedrigen Ansteuerleistung jedoch hochohmig dimensioniert sind, ergibt sich eine relativ große RC-Konstante und damit ein relativ langsamer Umschaltvorgang.

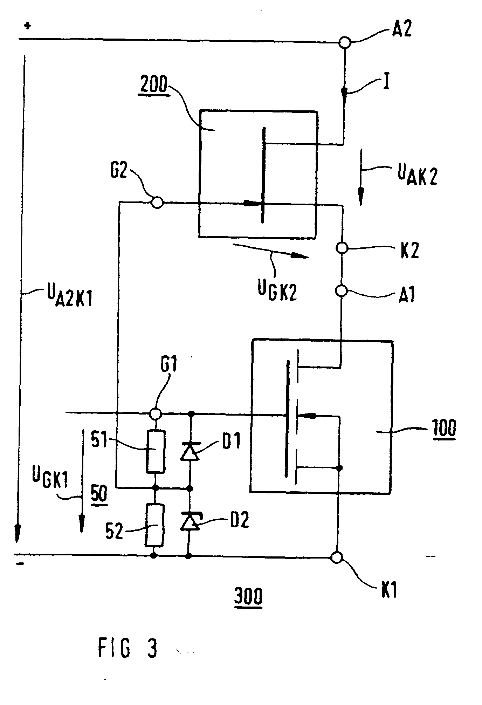

Um das dynamische Schaltverhalten zu verbessern, enthält die in Figur 3 gezeigte elektronische Schalteinrichtung 300 deshalb zusätzlich eine erste und eine zweite Diode D1 und D2, die parallel zum ersten bzw. zweiten Kopplungswiderstand 51 bzw. 52 geschaltet sind. Der Ladevorgang beim Umschalten vom Durchlaß- in den Sperrzustand erfolgt nun anstelle über den ersten Kopplungswiderstand 51 über die erste Diode D1, der Entladevorgang beim Umschalten vom Sperr- in den Durchlaßzustand anstelle über den zweiten Kopplungswiderstand 52 über die zweite Diode D2. Damit wird in beiden Fällen eine erheblich schnellere Schaltgeschwindigkeit erreicht. Im Durchlaß- oder Sperrzustand selbst ändert sich das vorstehend im Zusammenhang mit den Figuren 1 und 2 beschriebene Verhalten der elektronischen Schalteinrichtung 300 durch das Einfügen der beiden Dioden D1 und D2 nicht.

Die zweite Diode D2 ist als Zener-Diode mit einer Durchbruchspannung von kleiner gleich 3 V ausgeführt. Damit schützt sie zusätzlich vor der Kopplung eines zu hohen Anteils der Steuerspannung U_{GK1} auf den zweiten Gitteranschluß G2.

In einer nicht dargestellten Ausführungsform ist zusätzlich ein dem zweiten Gitteranschluß G2 vorgeschalteter weiterer Widerstand zur Feineinstellung der Schaltgeschwindigkeit oder am ersten Gitteranschluß G1 ein Widerstand zur Strombegrenzung im Fall einer negativen Steuerspannung U_{GK1} vorgesehen. Es können auch beide Widerstände gleichzeitig vorhanden sein.

Die elektronischen Schalteinrichtungen 300 der Figuren 1 bis 3 sind jeweils für eine im Sperrzustand anstehende Betriebsspannung U_{A2K1} von maximal bis zu 5000 V, sowie für einen im Durchlaßzustand fließenden Strom I von höchstens 1000 A, insbesondere von höchstens 500 A, ausgelegt. Ein Hauptanwendungsgebiet liegt bei einer im Sperrzustand maximal anstehenden Betriebsspannung U_{A2K1} im Bereich zwischen 1200 V und 1700 V und bei einem im Durchlaßzustand als Nennstrom fließenden Strom I im Bereich zwischen 10 A und 50 A.

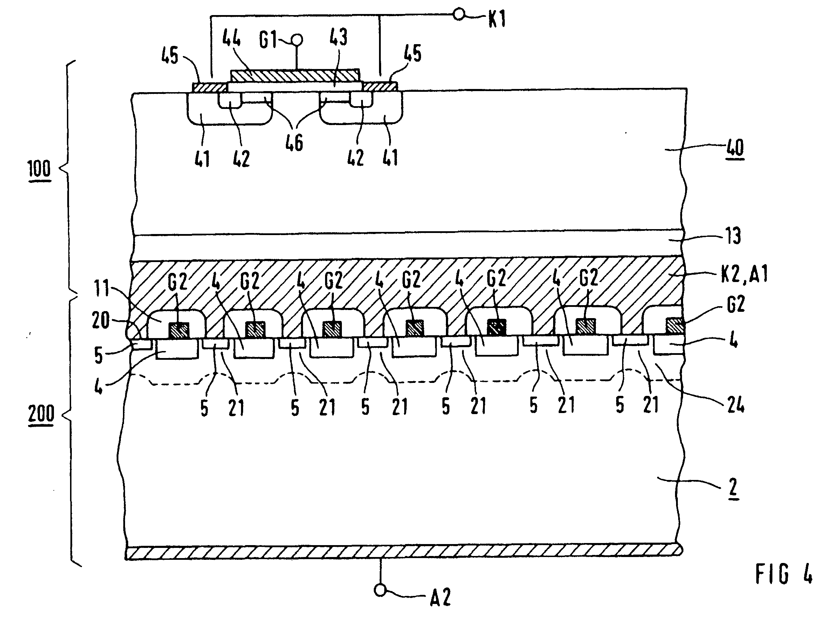

In dem Ausführungsbeispiel von Figur 4 sind das erste Halbleiterbauelement 100 und das zweite Halbleiterbauelement 200 zu einer hybriden Halbleiterstruktur integriert.

Das erste Halbleiterbauelement 100 ist ein an sich bekannter und deshalb nur schematisch dargestellter vertikaler Si-MOSFET in sogenannter DDMOS-Technik ("DD" steht hier für doppelt diffundiert). In einem n-leitenden Silicium-Wafer 40 sind p-leitende Basisgebiete 41 und in diese Basisgebiet 41 wiederum n-leitende Gebiete 42 eindiffundiert. Eine Gate-Elektrode 44 ist durch ein Isolatorgebiet 43 elektrisch von dem Basisgebiet 41 isoliert. Über die Gate-Elektrode 44 wird ein n-Kanal 46, der im Basisgebiet 41 eine n-leitende Verbindungszone zwischen dem Sourcegebiet 42 und dem Siliciumwafer 40 herstellt, gesteuert. Ohne ein entsprechendes Steuerpotential an der Gate-Elektrode 44 ist der n-Kanal 46 nicht vorhanden. Der Si-MOSFET ist selbstsperrend. Außerdem schließt eine Source-Elektrode 45 die Sourcegebiete 42 und die Basisgebiete 41 elektrisch kurz. In der Bezeichnungsweise der vorangehenden Figuren stellt die Gate-Elektrode 44 den ersten Gitteranschluß G1 und die Source-Elektrode 45 den ersten Kathodenanschluß K1 dar.

Das zweite Halbleiterbauelement 200 ist als SiC-JFET ausgebildet. Es besteht aus einem n-leitenden ersten Halbleitergebiet 2 aus Siliciumcarbid mit einer Oberfläche 20. An der Oberfläche 20 befinden sich innerhalb des ersten Halbleitergebietes 2 mehrere ebenfalls n-leitende Kontaktgebiete 5 und mehrere p-leitende zweite Halbleitergebiete 4. Die zweiten Halbleitergebiete 4 sind jeweils in einem außerhalb der Kontaktgebiete 5 liegenden Bereich des ersten Halbleitergebiets 2 angeordnet, so daß sich die Kontaktgebiete 5 und die zweiten Halbleitergebiete 4 nicht überlappen.

Die Kontaktgebiete 5 sind über eine Elektrodenschicht, die den zweiten Kathodenanschluß K2 bildet, ohmsch kontaktiert. Die zweiten Halbleitergebiete 4 sind über Elektroden, die miteinander verbunden sind und gemeinsam den zweiten Gitteranschluß G2 darstellen, ohmsch kontaktiert. Die Elektrodenschicht des zweiten Kathodenanschlusses K2 und die Elektroden des zweiten Gitteranschlusses G2 sind über eine Isolationsschicht 11 elektrisch voneinander isoliert.

Die Kontaktgebiete 5 können dabei entweder gleich wie oder auch höher als das erste Halbleitergebiet 2 dotiert sein. Bei einer höheren Dotierung ergibt sich eine bessere ohmsche Kontaktierung des zweiten Kathodenanschlusses K2.

Die Isolationsschicht 11 besteht aus einem Oxid, vorzugsweise aus dem Dielektrikum Siliciumdioxid (SiO₂), das insbesondere thermisch gewachsen wird. Thermisches Oxid weist hervorragende Isolationseigenschaften auf und kann auf SiC durch Trocken- oder Naßoxidation bei Temperaturen über 1000°C erzeugt werden.

Zwischen den p-leitenden zweiten Halbleitergebieten 4 und dem n-leitenden ersten Halbleitergebiet 2 befindet sich jeweils ein p-n-Übergang mit einer Verarmungszone 24. Da die zweiten Halbleitergebiete 4 höher dotiert sind als das erste Halbleitergebiet 2, erstrecken sich die Verarmungszonen 24 weiter in das erste Halbleitergebiet 2 als in die zweiten Halbleitergebiete 4. Zwischen den zweiten Halbleitergebieten 4 befinden sich vertikale Kanalgebiete 21, in denen der Strom I im Durchlaßzustand fließt. Die vertikalen Kanalgebiete 21 erstrecken sich sowohl in die ersten Kontaktgebiete 5 als auch in die daran angrenzenden Bereiche des ersten Halbleitergebietes 2. Über die Kontaktgebiete 5 sind die vertikalen Kanalgebiete 21 mit dem zweiten Kathodenanschluß K2 elektrisch verbunden. Im Durchlaßzustand fließt der Strom I durch die vertikalen Kanalgebiete 21 und im Anschluß daran durch das erste Halbleitergebiet 2 zu dem auf der der Oberfläche 20 abgewandten Seite des ersten Halbleitergebiets 2 angeordneten zweiten Anodenanschluß A2. Dieser ist ebenfalls als Elektrodenschicht ausgebildet.

In dem in Figur 4 dargestellten Sperrzustand dehnen sich die Verarmungszonen 24 der p-n-Übergänge zwischen dem ersten Halbleitergebiet 2 und den zweiten Halbleitergebieten 4 soweit aus, daß sie die vertikalen Kanalgebiete 21 abschnüren und, wie in Figur 4 durch die gestrichelte Linie angedeutet, vollständig überdecken. Ein Stromfluß findet im Sperrzustand somit praktisch nicht mehr statt. Die einzelnen Verarmungszonen 24 verbinden sich zu einer einzigen großen Verarmungszone 24, innerhalb derer die beweglichen Ladungsträger praktisch vollständig ausgeräumt sind. Diese große Verarmungszone trägt dann einen großen Teil der (Sperr-)Spannung. Der verbleibende Teil der (Sperr-)Spannung wird im wesentlichen in einer Driftzone des ersten Halbleitergebietes 2 aufgenommen. Die Sperrfähigkeit der einen großen Verarmungszone 24 wird dabei sowohl durch die geometrischen Abmessungen als auch durch die Dotierungen des ersten Halbleitergebietes 2, der zweiten Halbleitergebiete 4 und der Kontaktgebiete 5 bestimmt. Bei vorgegebener Abmessung wird die Dotierung des ersten Halbleitergebiets 2 zumindest innerhalb der vertikalen Kanalgebiete 21 um so niedriger gewählt, je höher die gewünschte (Sperr-)Spannung ist. Typische Werte für die n-Dotierung des dargestellten ersten Halbleitergebiets 2 bei Verwendung von Siliciumcarbid des 4H-Polytyps sind n = 1·10¹⁶ cm⁻³ für eine an den Verarmungszonen 24 der p-n-Übergänge anstehende maximale (Sperr-)Spannung Uₘₐₓ = 600 V, n = 8·10¹⁵ cm⁻³ für Uₘₐₓ = 1200 V und n = 5·10¹⁵ cm⁻³ für Uₘₐₓ = 1800 V.

In der hybriden Halbleiterstruktur von Figur 4 ist die Elektrodenschicht des zweiten Kathodenanschlusses K2 zugleich auch dem ersten Anodenanschluß A1 des ersten Halbleiterbauelements 100 zugeordnet. Auf diese Elektrodenschicht ist eine Verbindungsschicht 13 und darüber der Silicium-Wafer 40 mit der eigentlichen Struktur des Si-MOSFETs angeordnet. Die Verbindungsschicht 13 ist nicht zwingend notwendig, sondern nur optional. Sie dient dem Abbau etwaiger mechanischer Spannungen und besteht deshalb vorzugsweise aus einem duktilen Metall, wie z.B. aus Gold (Au), Silber (Ag), Kupfer (Cu) oder Aluminium (A1). Zum Verbinden (Bonden) kann insbesondere eine Löttechnik (Chip-on-chip-Lötung), eine Bonddrahtverbindungstechnik oder auch direktes Waferbonding eingesetzt werden. Als Vorteil erweist sich bei dieser Anordnung, daß die Zonen aus Silicium- und Siliciumcarbid-Halbleitermaterial an keiner Stelle in unmittelbarem Kontakt miteinander treten. Dies würde andernfalls zu unerwünschten mechanischen Spannungen innerhalb der hybriden Halbleiterstruktur führen.

Die Elektrodenschichten und auch die Einzelelektroden der hybriden Halbleiterstruktur, die den jeweiligen Anoden-Kathoden- und Gitteranschlüssen A1, A2, K1, K2, G1 bzw. G2 zugeordnet sind, bestehen aus Polysilicium oder einem Metall, vorzugsweise aus Nickel (Ni), Tantal (Ta), Titan (Ti), Wolfram (W) oder Aluminium (Al) oder aus einer Metallverbindung mit einem der genannten Metalle als Bestandteil.

Das in Figur 4 dargestellte Ausführungsbeispiel des SiC-JFETs als zweites Halbleiterbauelement 200 enthält mehrere identische Halbleiterzellen, die nebeneinander angeordnet sind. Das beschriebene Prinzip ist jedoch genau so gut für einen Aufbau mit nur einer einzigen der beschriebenen Halbleiterzellen möglich.

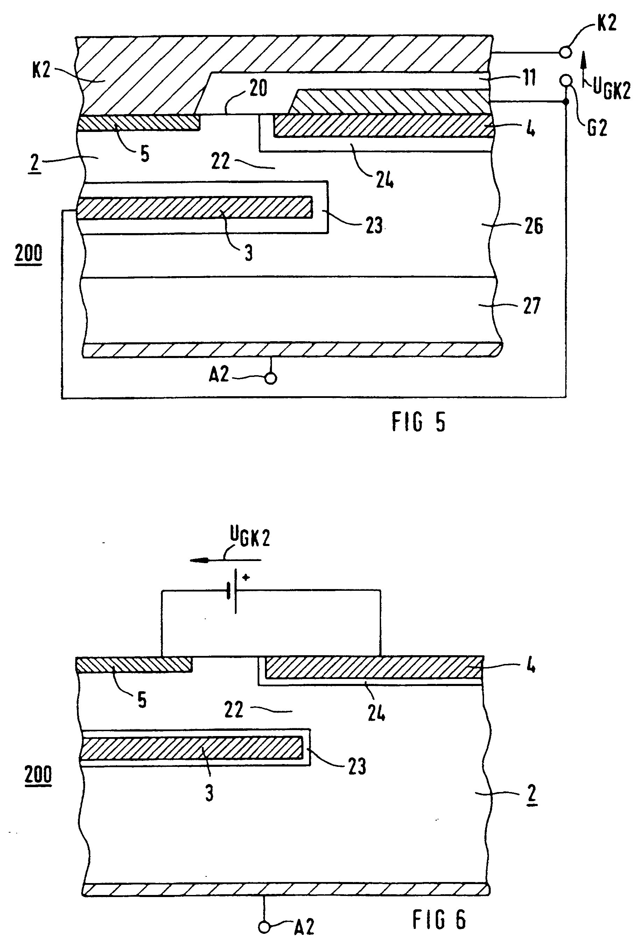

In Figur 5 ist eine Abwandlung der Halbleiterzellen des SiC-JFETs von Figur 4 dargestellt. Als wesentlicher Unterschied enthält das in Figur 5 dargestellte, als SiC-JFET ausgebildete zweite Halbleiterbauelement 200 ein innerhalb des ersten Halbleitergebiets 2 vergrabenes p-leitendes Inselgebiet 3.

Das erste Halbleitergebiet 2 besteht aus einem n-leitenden Substrat 27 aus SiC und einer darauf angeordneten, epitaktisch aufgewachsenen ebenfalls n-leitenden Halbleiterschicht 26 aus SiC. Im allgemeinen weist sie eine niedrigere Ladungsträgerkonzentration als das Substrat 27 auf.

Das vergrabene Inselgebiet 3 ist so angeordnet, daß in einer Projektion senkrecht zur Oberfläche 20 die Projektion des Kontaktgebiets 5 vollständig in der Projektion des vergrabenen Inselgebiets 3 liegt. Außerdem überlappen sich die Projektionen des vergrabenen Inselgebiets 3 und des zweiten Halbleitergebiets 4 an ihren Rändern. Innerhalb des Bereichs dieser Überlappung befindet sich in dem ersten Halbleitergebiet 2 ein laterales Kanalgebiet 22, das parallel zu der Oberfläche 20 verläuft. Dieses laterale Kanalgebiet 22 wird an seinen seitlichen Rändern durch die Raumladungszone 24 des p-n-Übergangs zwischen dem ersten Halbleitergebiet 2 und dem zweiten Halbleitergebiet 4 und durch eine Raumladungszone 23 eines weiteren p-n-Übergangs zwischen dem ersten Halbleitergebiet 2 und dem vergrabenen Inselgebiet 3 begrenzt.

Das vergrabene Inselgebiet 3 und das zweite Halbleitergebiet 4 sind elektrisch leitend miteinander verbunden und über den zweiten Gitteranschluß G2 elektrisch kontaktiert. Im Durchlaßzustand der elektronischen Schalteinrichtung 300 fließt der Strom I durch das laterale Kanalgebiet 22. Je größer die geometrischen Abmessungen des lateralen Kanalgebiets 22 sind, desto niedriger ist auch der Durchlaßwiderstand des zweiten Halbleiterbauelements 200. Über die räumliche Ausdehnung der Verarmungszonen 23 und 24 läßt sich somit der Widerstand innerhalb des lateralen Kanalgebiets 22 einstellen.

Falls, wie beim Stand der Technik, eine elektrische Verbindung des zweiten Gitteranschlusses G2 mit dem ersten Kathodenanschluß K1 vorgesehen ist, ergibt sich bei steigendem elektrischen Strom I eine zunehmend negative Gitter-Kathoden-Spannung U_{GK2}, wodurch sich die Verarmungszonen 23 und 24 weiter ausdehnen und somit den Widerstand im lateralen Kanalgebiet 22 erhöhen. Legt man dagegen erfindungsgemäß eine positive Gitter-Kathoden-Spannung U_{GK2} am zweiten Halbleiterbauelement 200 an, so resultiert daraus, wie in Figur 6 dargestellt, ein Zurückweichen der Raumladungszonen 23 und 24. Eine Reduzierung des Widerstands im lateralen Kanalgebiet 22 geht damit einher. Um diesen Sachverhalt zu verdeutlichen, sind in Figur 6 nur die diesbezüglich relevanten Zeichnungsteile von Figur 5 nochmals dargestellt. Durch die Kopplung eines Teils der Steuerspannung U_{GK1} auf den zweiten Gitteranschluß G2 erreicht man gerade eine positive Gitter-Kathoden-Spannung U_{GK2} mit der genannten vorteilhaften Wirkung.

Der erste Kopplungswiderstand 51 oder der Spannungsteiler 50 ist dabei so dimensioniert, daß die Gitter-Kathoden-Spannung U_{GK2} die Diffusionsspannung an den p-n-Übergängen zwischen dem zweiten Halbleitergebiet 4 und dem vergrabenen Inselgebiet 3 einerseits und dem ersten Halbleitergebiet 2 andererseits nicht überschreitet. Insbesondere nimmt die Gitter-Kathoden-Spannung U_{GK2} höchstens einen Wert von 2/3 der Diffusionsspannung an. Die Diffusionsspannung ist abhängig von den Dotierungen der jeweiligen Halbleitergebiete und auch von dem verwendeten Halbleitermaterial. Für Siliciumcarbid liegt die Diffusionsspannung in der Größenordnung von etwa 3 V. Bei dem "Universalhalbleiter" Silicium bewegt sich die Diffusionsspannung in der Größenordnung von 0,7 V. Mit diesen Werten für die Diffusionsspannung ergibt sich unmittelbar, daß eine entsprechende Reduzierung der Verarmungszonen 23 und 24 vorteilhaft vor allem bei Siliciumcarbid vorgesehen werden kann, wohingegen sich eine entsprechende Maßnahme bei Silicium wegen der materialbedingt niedrigeren Diffusionsspannung gar nicht oder zumindest nur mit wesentlich geringerem Effekt anwenden läßt.

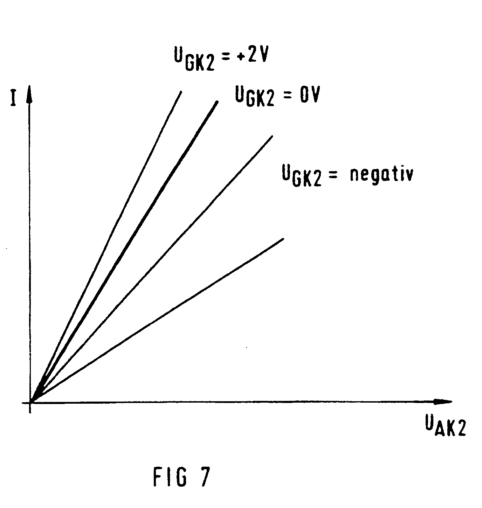

In Figur 7 ist ein Ausgangskennlinienfeld des in den Figuren 5 und 6 dargestellten SiC-JFETs dargestellt. In dem Diagramm ist der elektrische Strom I über der Anoden-Kathoden-Spannung U_{AK2} des zweiten Halbleiterbauelements 200 im linearen Bereich aufgetragen. Die Gitter-Kathoden-Spannung U_{GK2} ist dabei der Parameterwert des Ausgangskennlinienfelds. Man kann dem Diagramm von Figur 7 entnehmen, daß bei einer positiven Gitter-Kathoden-Spannung U_{GK2} von 2 V eine deutlich steilere Kennlinie resultiert als bei den negativen Werten der Gitter-Kathoden-Spannung U_{GK2}, die bei den Ausführungsformen des Standes der Technik auftreten. Da die Kennliniensteilheit gerade dem Durchlaßwiderstand des zweiten Halbleiterbauelements 200 entspricht, kann die erzielbare Verbesserung anhand der gemessenen Kennlinien von Figur 7 unmittelbar abgelesen werden.

Es versteht sich, daß alle genannten Halbleiter-Leitungstypen auch gegen den jeweils komplementären ausgetauscht werden können.

## Patentansprüche

1. Elektronische Schalteinrichtung umfassend mindestens
a) ein erstes Halbleiterbauelement (100) mit einem ersten Kathodenanschluß (K1), einem ersten Anodenanschluß (A1) und einem ersten Gitteranschluß (G1) und
b) ein zweites Halbleiterbauelement (200) mit einem zweiten Kathodenanschluß (K2), einem zweiten Anodenanschluß (A2) und einem zweiten Gitteranschluß (G2), wobei
c) der erste Anodenanschluß (A1) und der zweite Kathodenanschluß (K2) elektrisch kurzgeschlossen sind, und
d) eine am ersten Gitteranschluß (G1) anlegbare Steuerspannung (U_{GK1}) teilweise auch am zweiten Gitteranschluß (G2) ansteht,
**gekennzeichnet durch**
e) Einstellungsmittel (50, 51) zum Einstellen einer Gitter-Kathoden-Spannung (U_{GK2}) des zweiten Halbleiterbauelements (200), die kleiner ist als eine Diffusionsspannung eines p-n-Übergangs, der sich innerhalb des zweiten Halbleiterbauelements (200) zwischen dem zweiten Gitteranschluß (G2) und dem zweiten Kathodenanschluß (K2) befindet.

2. Elektronische Schalteinrichtung nach Anspruch 1, **dadurch gekennzeichnet, daß** die Einstellungsmittel (50, 51) ausgelegt sind zur Einstellung einer Gitter-Kathoden-Spannung (U_{GK2}) des zweiten Halbleiterbauelements (200) mit einem Wert von höchstens zwei Dritteln der Diffusionsspannung des p-n-Übergangs.

3. Elektronische Schalteinrichtung nach Anspruch 1 oder 2, **dadurch gekennzeichnet, daß** der erste Gitteranschluß (G1) mit dem zweiten Gitteranschluß (G2) über einen ersten Kopplungswiderstand (51) elektrisch verbunden ist.

4. Elektronische Schalteinrichtung nach einem der Ansprüche 1 bis 3, **dadurch gekennzeichnet, daß** zwischen dem ersten Gitteranschluß (G1) und dem ersten Kathodenanschluß (K1) ein Spannungsteiler (50) mit einem ersten Kopplungswiderstand (51) und einem zweiten Kopplungswiderstand (52) vorgesehen ist, wobei die beiden Kopplungswiderstände (51, 52) und der zweite Gitteranschluß (G2) elektrisch leitend miteinander verbunden sind.

5. Elektronische Schalteinrichtung nach Anspruch 4, **dadurch gekennzeichnet, daß** eine erste Diode (D1) parallel zu dem ersten Kopplungswiderstand (51) und eine zweite Diode (D2) parallel zu dem zweiten Kopplungswiderstand (52) geschaltet sind.

6. Elektronische Schalteinrichtung nach einem der Ansprüche 3 bis 5 , **dadurch gekennzeichnet, daß** der erste Kopplungswiderstand (51) oder der Spannungsteiler (50) rein ohmsch ist.

7. Elektronische Schalteinrichtung nach einem der vorhergehenden Ansprüche, **dadurch gekennzeichnet, daß** das erste Halbleiterbauelement (100) aus dem Halbleitermaterial Silicium besteht.

8. Elektronische Schalteinrichtung nach einem der vorhergehenden Ansprüche, **dadurch gekennzeichnet, daß** das erste Halbleiterbauelement (100) als selbstsperrender MOS-Feldeffekttransistor, insbesondere mit n-leitendem Kanal, ausgebildet ist.

9. Elektronische Schalteinrichtung nach einem der vorhergehenden Ansprüche, **dadurch gekennzeichnet, daß** das zweite Halbleiterbauelement (200) aus dem Halbleitermaterial Siliciumcarbid besteht.

10. Elektronische Schalteinrichtung nach einem der vorhergehenden Ansprüche, **dadurch gekennzeichnet, daß** das zweite Halbleiterbauelement (200) als selbstleitender Feldeffekttransistor, insbesondere als Sperrschicht-Feldeffekttransistor, ausgebildet ist.

11. Elektronische Schalteinrichtung nach Anspruch 10 , **dadurch gekennzeichnet, daß** der selbstleitende Sperrschicht-Feldeffekttransistor (200) ein n-leitendes erstes Halbleitergebiet (2) mit einer Oberfläche (20) umfaßt, wobei mindestens ein n-leitendes Kontaktgebiet (5), das sich an der Oberfläche (20) innerhalb des ersten Halbleitergebiets (2) befindet, über den zweiten Kathodenanschluß (K2), mindestens ein außerhalb des Kontaktgebiets (5) liegender Bereich der Oberfläche (20) über den zweiten Gitteranschluß (G2) und das erste Halbleitergebiet (2) an einer der Oberfläche (20) abgewandten Seite über den zweiten Anodenanschluß (A2) elektrisch kontaktiert sind.

12. Elektronische Schalteinrichtung nach Anspruch 11, **dadurch gekennzeichnet, daß** der selbstleitende Sperrschicht-Feldeffekttransistor (200) mindestens ein p-leitendes zweites Halbleitergebiet (4) umfaßt, das innerhalb des ersten Halbleitergebiets (2) an der Oberfläche (20) angeordnet ist und das durch den zweiten Gitteranschluß (G2) ohmsch kontaktiert ist.

13. Elektronische Schalteinrichtung nach Anspruch 11 oder 12, **dadurch gekennzeichnet, daß** der selbstleitende Sperrschicht-Feldeffekttransistor (200) mindestens ein innerhalb des ersten Halbleitergebiets (2) vergrabenes p-leitendes Inselgebiet (3) umfaßt, das unterhalb des mindestens einen Kontaktgebiets (5) so angeordnet ist, daß in einer Projektion senkrecht zur Oberfläche (20) die Projektion des Kontaktgebiets (5) vollständig innerhalb der Projektion des vergrabenen Inselgebiets (3) liegt.

14. Elektronische Schalteinrichtung nach Anspruch 13, **dadurch gekennzeichnet, daß** das mindestens eine vergrabene Inselgebiet (3) ebenfalls mit dem zweiten Gitteranschluß (G2) elektrisch leitend verbunden ist.

15. Elektronische Schalteinrichtung nach einem der vorhergehenden Ansprüche , **gekennzeichnet durch** eine Auslegung auf eine zwischen dem ersten Kathodenanschluß (K1) und dem ersten Gitteranschluß (G1) anlegbare Steuerspannung (U_{GK1}) von zwischen 5 V und 30 V.

16. Elektronische Schalteinrichtung nach einem der vorhergehenden Ansprüche, **dadurch gekennzeichnet, daß** sich in einem Sperrzustand der erste und der zweite Gitteranschluß (G1, G2) praktisch auf dem gleichen Potential befinden wie der erste Kathodenanschluß (K1).

17. Elektronische Schalteinrichtung nach einem der vorhergehenden Ansprüche, **gekennzeichnet durch** eine Auslegung auf eine zwischen dem ersten Kathodenanschluß (K1) und dem zweiten Anodenanschluß (A2) anlegbare Sperrspannung von bis zu 5000 V.

18. Elektronische Schalteinrichtung nach einem der vorhergehenden Ansprüche, **gekennzeichnet durch** eine Auslegung auf einen zwischen dem ersten Kathodenanschluß (K1) und dem zweiten Anodenanschluß (A2) fließenden Nennstrom von bis zu 1000 A, insbesondere von bis zu 500 A.

19. Elektronische Schalteinrichtung nach einem der vorhergehenden Ansprüche, **dadurch gekennzeichnet, daß** das erste Halbleiterbauelement (100) und das zweite Halbleiterbauelement (200) zu einer hybriden Halbleiterstruktur integriert sind.

## Claims

1. Electronic switching device comprising at least
a) a first semiconductor component (100) having a first cathode connection (K1), a first anode connection (A1) and a first grid connection (G1), and
b) a second semiconductor component (200) having a second cathode connection (K2), a second anode connection (A2) and a second grid connection (G2), with
c) the first anode connection (A1) and the second cathode connection (K2) being electrically short-circuited, and
d) a control voltage (U_{GK1}) which can be applied to the first grid connection (G1) being partially present also at the second grid connection (G2),
**characterised by**
e) setting means (50, 51) for setting a grid-cathode voltage (U_{GK2}) of the second semiconductor component (200) which is less than a diffusion voltage of a p-n junction that is located between the second grid connection (G2) and the second cathode connection (K2) within the second semiconductor component (200).

2. Electronic switching device according to claim 1, **characterised in that** the setting means (50, 51) are embodied for setting a grid-cathode voltage (U_{GK2}) of the second semiconductor component (200) to a value of at most two-thirds of the diffusion voltage of the p-n junction.

3. Electronic switching device according to claim 1 or 2, **characterised in that** the first grid connection (G1) is electrically connected to the second grid connection (G2) via a first coupling resistance (51).

4. Electronic switching device according to one of the claims 1 to 3, **characterised in that** a voltage divider (50) having a first coupling resistance (51) and a second coupling resistance (52) is provided between the first grid connection (G1) and the first cathode connection (K1), with the two coupling resistances (51, 52) and the second grid connection (G2) being electrically conductively connected to one another.

5. Electronic switching device according to claim 4, **characterised in that** a first diode (D1) is connected in parallel with the first coupling resistance (51) and a second diode (D2) is connected in parallel with the second coupling resistance (52).

6. Electronic switching device according to one of the claims 3 to 5, **characterised in that** the first coupling resistance (51) or the voltage divider (50) is purely resistive.

7. Electronic switching device according to one of the preceding claims, **characterised in that** the first semiconductor component (100) is made of the semiconductor material silicon.

8. Electronic switching device according to one of the preceding claims, **characterised in that** the first semiconductor component (100) is embodied as a normally-off MOS field-effect transistor, in particular having an n-conductive channel.

9. Electronic switching device according to one of the preceding claims, **characterised in that** the second semiconductor component (200) is made of the semiconductor material silicon carbide.

10. Electronic switching device according to one of the preceding claims, **characterised in that** the second semiconductor component (200) is embodied as a normally-on field-effect transistor, in particular as a junction field-effect transistor.

11. Electronic switching device according to claim 10, **characterised in that** the normally-on junction field-effect transistor (200) comprises an n-conductive first semiconductor region (2) having a surface (20), with at least one n-conductive contact region (5) which is located on the surface (20) within the first semiconductor region (2) having electrical contact made via the second cathode connection (K2), at least one area of the surface (20) located outside of the contact region (5) having electrical contact made via the second grid connection (G2), and with the first semiconductor region (2) on a side facing away from the surface (20) having electrical contact made via the second anode connection (A2).

12. Electronic switching device according to claim 11, characteri*s*ed in that the normally-on junction field-effect transistor (200) comprises at least a p-conductive second semiconductor region (4) which is disposed on the surface (20) within the first semiconductor region (2) and with which resistive contact is made by means of the second grid connection (G2).

13. Electronic switching device according to claim 11 or 12, **characterised in that** the normally-on junction field-effect transistor (200) comprises at least one p-conductive island region (3) which is buried within the first semiconductor region (2) and disposed beneath the at least one contact region (5) such that in a projection at right angles to the surface (20) the projection of the contact region (5) is located completely within the projection of the buried island region (3).

14. Electronic switching device according to claim 13, **characterised in that** the at least one buried island region (3) is also electrically conductively connected to the second grid connection (G2).

15. Electronic switching device according to one of the preceding claims, **characterised by** a design that is geared to a control voltage (U_{GK1}) of between 5 V and 30 V which can be applied between the first cathode connection (K1) and the first grid connection (G1).

16. Electronic switching device according to one of the preceding claims, **characterised in that** in an off-state the first and the second grid connection (G1, G2) are at practically the same potential as the first cathode connection.

17. Electronic switching device according to one of the preceding claims, **characterised by** a design that is geared to a reverse voltage of up to 5000 V which can be applied between the first cathode connection (K1) and the second anode connection (A2).

18. Electronic switching device according to one of the preceding claims, **characterised by** a design that is geared to a rated current of up to 1000 A, in particular of up to 500 A, flowing between the first cathode connection (K1) and the second anode connection (A2).

19. Electronic switching device according to one of the preceding claims, **characterised in that** the first semiconductor component (100) and the second semiconductor component (200) are integrated to form a hybrid semiconductor structure.

## Revendications

1. Dispositif électronique de commutation, comprenant au moins
a) un premier composant (100) à semi-conducteur ayant une première borne (K1) de cathode, une première borne (A1) d'anode et une première borne (G1) de grille et
b) un deuxième composant (200) à semi-conducteur ayant une deuxième borne (K2) de cathode, une deuxième borne (A2) d'anode et une deuxième borne (G2) de grille, dans lequel
c) la première borne (A1) d'anode et la deuxième borne (K1) de cathode sont court-circuitées électriquement, et
d) une tension (U_{GK1}) de commande pouvant être appliquée à la première borne (G1) de grille est appliquée au moins en partie aussi à la deuxième borne (G2) de grille,
**caractérisé par**
e) des moyens (50, 51) de réglage d'une tension (U_{GK2}) de grille-cathode du deuxième composant (200) à semi-conducteur, qui est inférieure à une tension de diffusion d'une jonction p-n qui se trouve à l'intérieur du deuxième composant (200) à semi-conducteur entre la deuxième borne (G2) de grille et la deuxième borne (K2) de cathode.

2. Dispositif électronique de commutation suivant la revendication 1, **caractérisé en ce que** les moyens (50, 51) de réglage sont conçus pour régler une tension (U_{GK2}) de grille-cathode du deuxième composant (200) à semi-conducteur à une valeur représentant au plus les deux-tiers de la tension de diffusion de la jonction p-n.

3. Dispositif électronique de commutation suivant la revendication 1 ou 2, **caractérisé en ce que** la première borne (G1) de grille est reliée électriquement à la deuxième borne (G2) de grille par une première résistance (51) de couplage.

4. Dispositif électronique de commutation suivant l'une des revendications 1 à 3, **caractérisé en ce qu'**il est prévu, entre la première borne (G1) de grille et la première borne (K1) de cathode, un diviseur (50) de tension ayant une première résistance (51) de couplage et une deuxième résistance (52) de couplage, les deux résistances (51, 52) de couplage et la deuxième borne (G2) de grille étant reliées entre elles d'une manière conductrice de l'électricité.

5. Dispositif électronique de commutation suivant la revendication 4, **caractérisé en ce qu'**une première diode (D1) est montée en parallèle à la première résistance (51) de couplage et une deuxième diode (D2) est montée en parallèle à la deuxième résistance (52) de couplage.

6. Dispositif électronique de commutation suivant l'une des revendications 3 à 5, **caractérisé en ce que** la première résistance (51) de couplage ou le diviseur (50) de tension est purement ohmique.

7. Dispositif électronique de commutation suivant l'une des revendications précédentes, **caractérisé en ce que** le premier composant (100) à semi-conducteur est en le matériau semi-conducteur qu'est le silicium.

8. Dispositif électronique de commutation suivant l'une des revendications précédentes, **caractérisé en ce que** le premier composant (100) à semi-conducteur est constitué sous la forme d'un transistor à effet de champ MOS en mode d'enrichissement, notamment à canal de conductivité n.

9. Dispositif électronique de commutation suivant l'une des revendications précédentes, **caractérisé en ce que** le deuxième composant (200) à semi-conducteur est en le matériau semi-conducteur qu'est le carbure de silicium.

10. Dispositif électronique de commutation suivant l'une des revendications précédentes, **caractérisé en ce que** le deuxième composant (200) à semi-conducteur est constitué en transistor à effet de champ en mode d'appauvrissement, notamment en transistor à effet de champ à couche d'arrêt.

11. Dispositif électronique de commutation suivant la revendication 10, **caractérisé en ce que** le transistor (200) à effet de champ à couche d'arrêt en mode d'appauvrissement comprend une première zone (2) à semi-conducteur de conductivité du type n ayant une surface (20), au moins une zone (5) de contact de conductivité de type n qui se trouve à la surface (20) à l'intérieur de la première zone (2) à semi-conducteur étant mise en contact électriquement par la deuxième borne (2) de cathode, au moins une zone, se trouvant à l'extérieur de la zone (5) de contact, de la surface (20) étant mise en contact par la deuxième borne (G2) de grille, et la première zone (2) à semi-conducteur étant mise en contact d'un côté éloigné de la surface (20) par la deuxième borne (A2) d'anode.

12. Dispositif électronique de commutation suivant la revendication 11, **caractérisé en ce que** le transistor (200) à effet de champ à couche d'arrêt en mode d'appauvrissement comprend au moins une deuxième zone (4) à semi-conducteur de conductivité du type p, qui est disposée à l'intérieur de la première zone (2) à semi-conducteur à la surface (20) et qui est en contact ohmique par la deuxième borne (G2) de grille.

13. Dispositif électronique de commutation suivant la revendication 11 ou 12, **caractérisé en ce que** le transistor (200) à effet de champ à couche d'arrêt en mode d'appauvrissement comprend au moins une zone (3) d'îlot de conductivité du type p enterrée dans la première zone (2) à semi-conducteur et disposée en dessous de la au moins une zone (5) de contact, de façon à ce que, suivant une projection perpendiculaire à la surface (20), la projection de la zone (5) de contact se trouve entièrement dans la projection de la zone (3) d'îlot enterrée.

14. Dispositif électronique de commutation suivant la revendication 13, **caractérisé en ce qu'**au moins une zone (3) d'îlot enterrée est reliée d'une manière conductrice de l'électricité également à la deuxième borne (G2) de grille.

15. Dispositif électronique de commutation suivant l'une des revendications précédentes, **caractérisé par** une conception pour une tension (U_{GK1}) de commande pouvant être appliquée entre la première borne (K1) de cathode et la première borne (G1) de grille comprise entre 5 V et 30 V.

16. Dispositif électronique de commutation suivant l'une des revendications précédentes, **caractérisé en ce que**, dans un état de blocage, la première et la deuxième borne (G1, G2) de grille se trouvent pratiquement au même potentiel que la première borne (K1) de cathode.

17. Dispositif électronique de commutation suivant l'une des revendications précédentes, **caractérisé par** une conception pour une tension de blocage pouvant être appliquée entre la première borne (K1) de cathode et la deuxième borne (A2) d'anode allant jusqu'à 5000 V.

18. Dispositif électronique de commutation suivant l'une des revendications précédentes, **caractérisé par** une conception pour un courant nominal passant entre la première borne (K1) de cathode et la deuxième borne (A2) d'anode allant jusqu'à 1000 A, notamment jusqu'à 500 A.

19. Dispositif électronique de commutation suivant l'une des revendications précédentes, **caractérisé en ce que** le premier composant (100) à semi-conducteur et le deuxième composant (200) à semi-conducteur sont intégrés en une structure à semi-conducteur hybride.
